(19) Europäisches Patentamt
European Patent Office
Office européen des brevets

(11) Veröffentlichungsnummer: **0 017 159**
**B1**

(12) # EUROPÄISCHE PATENTSCHRIFT

(45) Veröffentlichungstag der Patentschrift: **09.02.83**

(51) Int. Cl.³: **H 03 H 15/02**

(21) Anmeldenummer: **80101606.4**

(22) Anmeldetag: **26.03.80**

(54) **Monolithisch integrierte Ladungsverschiebeschaltung.**

(30) Priorität: **30.03.79 DE 2912745**

(43) Veröffentlichungstag der Anmeldung: **15.10.80 Patentblatt 80/21**

(45) Bekanntmachung des Hinweises auf die Patenterteilung: **09.02.83 Patentblatt 83/6**

(84) Benannte Vertragsstaaten: **FR GB**

(56) Entgegenhaltungen:
**EP-A-0 006 053**
**EP-A-0 012 393**
**FR-A-2 349 236**
**US-A-4 056 737**
**IEEE JOURNAL OF SOLID-STATE CIRCUITS, Band SC-12, Nr. 6, Dezember 1977, NEW YORK (US), J. L. BERGER: »Cancellation of Aliasing in CCD Low-Pass Filters«, Seiten 617–625**

(73) Patentinhaber: **SIEMENS AKTIENGESELLSCHAFT, Berlin und München Wittelsbacherplatz 2, D-8000 München 2 (DE)**

(72) Erfinder: **Lüder, Rainer, Dr. Ing., Kohlstatt-Strasse 10, D-8024 Oberhaching (DE)**

**EP 0 017 159 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

Monolithisch integrierte Ladungsverschiebeschaltung

Die Erfindung bezieht sich auf eine monolithisch integrierte Ladungsverschiebeschaltung, insbesondere für nichtrekursive Filter, mit einem Signalabtaster, einem ersten durch den Signalabtaster mit Ladungspaketen versorgten, mit der Frequenz $f_A$ taktgesteuerten m-Phasen-MIS-Ladungsverschiebesystem und einer diesem MIS-Ladungsverschiebesystem nachgeschalteten, der Wiederherstellung eines zeitkontinuierlichen Signals dienenden, taktgesteuerten, interpolierenden Ausgangsstufe mit Abtast-Halteglied, der ein Tiefpaß nachgeschaltet ist.

Eine solche Ladungsverschiebeschaltung ist z. B. in der EP-A-0 006 053 beschrieben. Weiterhin findet man die Grundlagen über MIS-Ladungsverschiebesysteme mit Taktsteuerung in der Literaturstelle »Der Elektroniker« Nr. 2/1978, S. EL3 – EL6. Weiter kann in diesem Zusammenhang die Literaturstelle »Der Elektroniker« Nr. 3/1978, S. EL7 – EL15 genannt werden.

Bei der Übertragung von Signalen durch Abtastsysteme bewirkt die Abtastung eine Periodizität im Frequenzspektrum des abgetasteten Signals, die bei der Umwandlung in zeitlich kontinuierliche Signale durch geeignete Filter beseitigt werden muß, da die höheren Spektralanteile bei Vielfachen der Abtastfrequenz häufig stören. Dies bedeutet, daß man das Problem zu lösen hat, aus dem aus Abtastwerten gebildeten Ausgangssignal einer Ladungsverschiebeschaltung ein bandbegrenztes Signal wiederzugewinnen, bei dem die durch die Abtastung entstandenen höheren Spektralanteile hinreichend gedämpft werden.

Zur Interpolation der Abtastwerte dient in der Regel ein Abtast-Halteglied und ein nachfolgender analoger Tiefpaß. In vielen Fällen ist für das anzuwendende Tiefpaßfilter ein RC-Filter unzureichend, so daß man LC-Filter anzuwenden hat. Damit entfällt aber die Möglichkeit, das Filter mit den übrigen Teilen der Ladungsverschiebeschaltung monolithisch auf einem gemeinsamen Halbleiterchip zu integrieren. Eine voll integrierbare Lösung des Problems ist jedoch für CCD-Schaltungen (= Ladungsverschiebeschaltungen), die z. B. zur Realisierung von Filter- oder Verzögerungsschaltungen dienen sollen, von großer Bedeutung.

Es gibt nun zwei Möglichkeiten, um die Selektionsanforderungen an den Tiefpaß zu reduzieren: 1.) man erhöht die Abtastfrequenz $f_A$ des CCD, oder 2.) man schaltet einen weiteren — mit der Abtastfrequenz $f_A'$ — arbeitenden CCD-Tiefpaß dem ersten CCD nach, wobei die Abtastfrequenz $f_A'$ des Tiefpasses größer als die Abtastfrequenz $f_A$ des ersten CCD's ist. Dann kann der nachfolgende analoge Tiefpaß sehr einfach ausgebildet werden oder ggf. ganz entfallen.

Eine höhere Abtastfrequenz in einer CCD-Anlage (Fall 1.)) erhöht aber — bei gleichen Systemanforderungen — proportional die Zahl N der Ladungstransportelemente und damit den Flächenbedarf für die Schaltung auf dem Halbleiterchip und führt außerdem in der Regel infolge erhöhten Ladungstransport-Verlusten (N) zu schlechteren Systemeigenschaften. Ebenso ist der Aufwand für einen nachfolgenden CCD-Tiefpaß höherer Abtastfrequenz $f_A'$ — bedingt durch die erforderliche Takterzeugung — verhältnismäßig groß.

In der bereits genannten EP-A-12 393 ist eine taktgesteuerte monolithisch integrierbare Abtastschaltung, an deren Eingang das abzutastende und durch ein Vorfilter bandbegrenzte Analogsignal zu legen ist und die ein aus m parallelen Zweigen bestehendes erstes Abtastsystem enthält, dessen Abtastwerte das Eingangssignal des zweiten — eigentlichen — Abtastsystems bilden und die auf der Basis von Ladungsverschiebeschaltungen aufgebaut ist. Dabei sind m Abtaster für das Analogsignal vorgesehen, die m Folgen von Abtastwerten liefern, die jeweils um die Zeitspanne T/m gegeneinander versetzt sind. Nach der Abtastung erfolgt eine Zeitverzögerung für jede der Folgen in der Weise, daß alle Abtastwerte danach in Phase sind. Jede Folge wird einem gesonderten Filter zugeführt, das wiederum als Abtastfilter ausgestaltet sein kann. Die m Ausgangsfolgen werden danach addiert und bilden eine neue Folge von Abtastwerten der Abtastfrequenz 1/T für das durch das zweite Abtastsystem gegebene eigentliche Abtastfilter. Dabei wird die Aufgabe gelöst, das Spektrum des analogen Systems vor der Abtastung so weit zu begrenzen, daß Faltungsprodukte, die in solchen Abtastschaltungen zwangsläufig entstehen, sich im Spektrum des Ausgangssignals nur wenig bemerkbar machen.

Bei dem sich ebenfalls mit CCD-Anlagen befassenden Stand der Technik nach der FR-PS 2 349 236 handelt es sich darum, ein CCD-Tiefpaßfilter derart auszugestalten, daß die aufgrund der Abtastung des zu übertragenden Signals bedingten Spiegelfrequenzen durch das Filter nicht übertragen werden. Hierzu wird das Tiefpaßfilter mit einem CCD-Vorfilter versehen, welches die Aufgabe hat, höhere Spektralanteile des Eingangssignals zu unterdrücken, um den Bedingungen für die nachfolgende und das Filter darstellende CCD-Anlage hinsichtlich des Abtasttheorems (Nyquisttheorems) zu erfüllen. Das Vorfilter bei einer CCD-Anlage nach der FR-PS dient somit als Antialiasing-Filter, und ist deshalb für die Lösung der nun anzugebenden und durch die vorliegende Erfindung zu lösenden Aufgabe nicht geeignet.

Die Erfindung befaßt sich mit dem bereits obenerwähnten Problem der Vermeidung einer durch die Abtastung bedingten Periodizität im Ausgangssignal. Sie hat die Aufgabe, eine Lösung anzugeben, die ohne Erhöhung der Abtastfrequenz $f_A$ und ohne ein mit erhöhter Abtastfrequenz arbeitendes CCD-Tiefpaßfilter auskommt, und die andererseits die Anwendung eines einfachen RC-Tiefpaßfilters

am Signalausgang und damit die volle Integrierbarkeit der Anlage gestattet, ohne daß dieser Vorteil mit einem Verzicht an Güte der Wiedergabe erkauft werden muß.

Erfindungsgemäß wird hierzu eine der eingangs gegebenen Definition entsprechende Ladungsverschiebeschaltung derart ausgestaltet, daß m MIS-Ladungsverschiebesysteme, wobei m eine ganze Zahl größer/gleich 2 ist, parallel an den Ausgang des ersten Ladungsverschiebesystems angekoppelt sind und daß die den parallelen MIS-Ladungsverschiebesystemen zugeführten Ladungen durch gewichtete Aufspaltung des vom ersten Ladungsverschiebesystem abgegebenen Ladungspakets entstehen, daß außerdem zur Steuerung dieser parallelen MIS-Ladungsverschiebesysteme dieselben m-phasigen Schiebetakte der Frequenz $f_A$ vorgesehen sind und daß außerdem diese MIS-Ladungsverschiebesysteme Filter gleicher oder unterschiedlicher Art bilden, daß ferner die von den parallelen Ladungsverschiebesystemen abgegebenen Ladungspakete mit voneinander um $1/m \cdot f_A$ abgestuften Zeiten verzögert und nach Umwandlung in eine Spannung zyklisch mit einer gegenüber der ersten Signalabtastfrequenz $f_A$ um den Faktor m höheren Abtastfrequenz $f_A'$ abgetastet werden und daß die Glättung dieser abgetasteten und gehaltenen Spannung durch ein integrationsfähiges, toleranzunempfindliches RC-Tiefpaßfilter realisiert ist.

Das der vorgeschlagenen Vorrichtung zugrunde liegende Verfahren führt eine Interpolation der Abtastwerte des CCD-Ausgangssignals in einer erweiterten CCD-Ausgangsschaltung aus. Die Wirkung ist die eines CCD-Tiefpasses mit höherer Taktfrequenz, so daß die interpolierende Ausgangsstufe Abtastwerte mit erhöhter Abtastrate abgibt.

Das erste Ladungsverschiebesystem, dem die interpolierende Ausgangsstufe folgt, sei ein m-Phasen-CCD mit einer Abtastfrequenz $f_A$ (mit z. B. m = 3 oder 4). Am Eingang der Ausgangsstufe wird das Ladungspaket des m-Phasen-CCD's gewichtet aufgespalten und m verschiedenen CCD-Schaltungen zugeführt, die jeweils nach dem Prinzip der gewichteten Ladungsaufspaltung und der unterschiedlichen Verzögerung der Ladungen in diesen Zweigen Filtereigenschaften besitzen. Nach diesen Filtern werden die Ladungen unterschiedlich verzögert, wobei diese Verzögerungen beim m-Phasen-CCD ein Vielfaches von $1/mf_A$ betragen. Die Ladungen gelangen, jeweils um $1/mf_A$ versetzt, in das übliche Diffusionsgebiet. Die dabei entstehende Spannung wird durch ein Abtasthalteglied mit der Frequenz $mf_A$ abgetastet. Da beim m-Phasen-CCD die Taktphasen $\Phi_1, \ldots, \Phi_m$ vorteilhaft aus der Frequenz $mf_A$ durch Teilung abgeleitet werden, ist der zusätzliche Aufwand für die Takterzeugung gering. Ebenso ist eine Verzögerung jeweils um den Betrag $i/mf_A$ mit $i = 1, 2, \ldots, m$ durch Anwendung von i Elektroden leicht möglich.

Die Erfindung wird nun anhand der Fig. 1 bis 10 näher beschrieben, wobei den Betrachtungen ein m-Phasen-CCD zugrundeliegt.

Wird ein Signal $x_e(t)$ durch ein solches CCD übertragen und eine Taktfrequenz $f_A$ angewendet, so besteht das Ausgangssignal $x_i$ aus Abtastwerten $x_i(nT)$ mit $T = f_A^{-1}$. Das Spektrum $X_i(\omega)$ ist periodisch mit der Abtastfrequenz $f_A$. Um ein zeitkontinuierliches, bandbegrenztes Signal $x_a(t)$ wiederzugewinnen, werden die Abtastwerte meist einem Abtast-Halteglied zugeführt, das höhere Spektralanteile von $X_i(\omega)$ durch die Übertragungsfunktion $H_{SH}(\omega)$ dämpft, wobei

$$H_{SH}(\omega) = \sin(\omega T/2)/(\omega T/2)$$

ist. In der Regel muß außerdem ein Tiefpaß nachgeschaltet werden, um eine ausreichende Dämpfung des Spektrums $X_{ao}(\omega)$ für Frequenzen f zu erzielen, die größer als $f_A/2$ sind.

Damit ergibt sich das in Fig. 1 dargestellte Schema eines Abtastsystems, bestehend aus Abtaster, CCD mit nachfolgendem Abtast-Halteglied S + H und Tiefpaß TP.

Die bei Anwendungen von CCD-Schaltungen zumeist erforderliche hohe Dämpfung der höheren Spektralanteile von $X_i(\omega)$ läßt sich bei der üblichen Ausgestaltung als integrierte Schaltung nicht ohne weiteres erreichen. Es besteht lediglich die bereits angedeutete Möglichkeit, ein CCD-Tiefpaßfilter, das mit der höheren Abtastfrequenz $f_A' > f_A$ arbeitet und das aus den Abtastwerten $x_i(nT)$ interpolierte Abtastwerte $x_A(lT')$ mit $T' = f_A'^{-1}$ liefert, dem ersten CCD mit der Übertragungsfunktion $H(\omega)$ folgen zu lassen, so daß man zu der aus Fig. 2 ersichtlichen Ausgestaltung gelangt. Dann kann der dem Abtast-Halteglied S + H nachgeschaltete Tiefpaß TP als einfacher Tiefpaß, also nur mit Widerständen und Kapazitäten, ausgestaltet sein. Allerdings ist damit der bereits angedeutete hohe Aufwand bei der Erzeugung der Taktfrequenz $f_A'$ gegeben.

Die Erfindung gibt ein Verfahren an, das die Eigenschaften des zuvor erwähnten CCD-Tiefpasses der Abtastfrequenz $f_A'$ in einer Ausgangsschaltung der ersten CCD-Schaltung vereinigt. Dieses Prinzip soll nun anhand der Fig. 3 und 4 beschrieben werden.

Die Abtastwerte $x_i(nT)$ werden m parallelen Filtern $H_j(z)$ zugeführt, wobei $j = 1, 2, \ldots, m$ ist. Die Ausgangssignale $x_j(nT)$ dieser Filter werden jeweils um die Zeitspanne $(j-1)T'$ verzögert, worin $T' = T/m$ bedeutet. Die Summe dieser verzögerten Abtastwerte $x_j''$ ergibt das Ausgangssignal $X_A(lT')$, das nun die höhere Abtastrate $f_A'$ aufweist. Fig. 5 zeigt diese Signale für das Beispiel m = 4 in Fig. 3.

Die Herleitung der Übertragungsfunktion $H_A$ der Ausgangsstufe wird erleichtert, wenn man die Signale $x_j(nT)$ als Abtastwerte $x_j'(lT')$ der Abtastfrequenz $f_A'$ darstellt, d. h. daß man das der Fig. 3 äquivalente mathematische Modell gemäß Fig. 4 verwendet. Dieses führt zu

$$x_j'(lT') = x_j(nT) \text{ mit } l = m \cdot n, \text{ und } n = 0, 1, 2, \qquad (1\,a)$$

$$x_j'(lT') = 0 \qquad l \neq m \cdot n \qquad (1\,b)$$

wobei

$$T' = T/m.$$

Damit gilt für die Z-Transformierten der Signale $x_j$ bzw. $x_j'$

$$X_j'(z') = X_j(z'^m) = X_j(z) \text{ mit } z = e^{i\omega T}, z' = e^{i\omega T'}. \qquad (2)$$

Damit erhält man für $X_A(z')$ die Darstellung

$$X_A(z') = \sum_j X_j''(z') = \sum_j X_j'(z') Z'^{-(j-1)} = \left(\sum_j H(z'^m) \cdot z'^{-j+1}\right) X_i(z'). \qquad (3)$$

Die Übertragungsfunktion der Ausgangsstoffe ist somit

$$H_A(z') = H_j(z'^m) z'^{-j+1}. \qquad (4)$$

Wird die Übertragungsfunktion $H_A(z')$ durch ein nichtrekursives Filter gebildet, dessen Funktion bekanntlich durch

$$H_A(z') = \sum_i a_i z'^i \qquad (5)$$

gegeben ist, so erhält man für die Filter $H_j(z'^m) = H_j(z)$ die Darstellung

$$H_j(z'^m) = a_{(j-1)} + a_{(m+j-1)} z'^{-m} + a_{(2m+j-1)} z'^{-2m} + \ldots \qquad (6\,a)$$

und

$$H_j(z) = a_{j-1} + a_{m+j-1} z^{-1} + a_{2m+j-1} z^{-2} + \ldots \qquad (6\,b)$$

Man kann somit nach Gleichung (5) eine Übertragungsfunktion $H_A(z')$ der interpolierenden Ausgangsstufe vorgegeben, die vorzugsweise die eines Tiefpasses der Abtastfrequenz $f_A' = mf_A$ ist. Daraus lassen sich nach Gleichung (6b) die Übertragungsfunktionen der m Filter $H_j(z)$ angeben, die als CCD-Filter mit der Abtastfrequenz $f_A$ realisiert werden können.

Bezüglich der praktischen Ausführung ist zunächst festzustellen, daß man in vielen Fällen die nichtrekursive Übertragungsfunktion $H_A(z')$ so wählen kann, daß die Koeffizienten $a_i$ nach Gleichung (5) ausschließlich positiv sind. Dann können die Filter $H_j(z'^m)$ durch Verzweigungsschaltungen realisiert werden.

Das Elektrodenmuster eines Beispiels eines CCD-Verzweigungsfilters ist in Fig. 6 dargestellt, wobei die Übertragungsfunktion durch

$$H(z) = (1-k) \cdot \left(1 + \frac{k \cdot z^{-1}}{(1-k)}\right)$$

gegeben ist. Dabei ist k der an der Verzweigungsstelle des CCD-Filters auf den einen Parallelzweig und (1 – k) der auf den anderen Parallelzweig übergehende Anteil der von links nach rechts geschobenen Ladungsmenge. Der Faktor k bzw. (1 – k) ist gleich dem Verhältnis der Fläche einer geteilten Elektrode zur Summe der Flächen aller geteilten parallel angeordneten Elektroden.

Das Ausgangssignal $x_i$ der CCD-Schaltung ist eine Ladung $q_i(nT)$, die — bei einem m-Phasen-CCD — durch gewichtete Aufspaltung in m-Zweige den CCD-Verzweigungsfiltern $H_j(z)$ zugeführt wird. Die Ausgangssignale $q_j(nT)$ werden durch $(j-1)$ Elektroden des m-Phasen-CCD's um $(j-1)T'$ verzögert. Die Ladungen gelangen, jeweils um die Zeitspanne T' versetzt, in ein Diffusionsgebiet D, dessen Potential üblicherweise durch einen Sourcefolger als Ausgangssignal $x_A(t)$ abgegeben wird. Man kommt auf diese Weise zu der in Fig. 7 dargestellten Ausgestaltung einer Vorrichtung gemäß der Erfindung.

Das Diffusionsgebiet D, dessen Potential üblicherweise durch einen Source-Folger SF, wie bereits bemerkt, als Ausgangssignal abgegeben wird, wird mit einer Frequenz $f_A' = T'^{-1}$ auf ein definiertes Potential zurückgesetzt. Das Signal $x_A(t)$ wird durch ein in üblicher Weise ausgestaltetes und in MOS-Technik günstig realisierbares Abtasthalteglied S + H mit der Frequenz $f_A'$ abgetastet und nach

einem einfachen Tiefpaßfilter (z. B. ein RC-Glied mit $f_g \approx f_A/2$) zum analogen Ausgangssignal $x_{ai}(t)$.

Da die m Taktsignale eines m-Phasen-CCD aus der Frequenz $f_A' = mf_A$ abgeleitet werden können, etnsteht kein großer zusätzlicher Aufwand für die Erzeugung des Rücksetz- und des Abtast-Taktes.

Das nun folgende Ausführungsbeispiel betrifft einen 4-Phasen-CCD-Tiefpaß mit $f_{3dB} = 4$ kHz, das für die Taktfrequenz $f_A = 24$ kHz dimensioniert ist, wobei ein Abtasthalteglied S+H und ein nachgeschalteter RC-Tiefpaß TP mit $f_g = 10$ kHz berücksichtigt werden. Die resultierende Übertragungsfunktion $H_0(2\pi f)$ zeigt, daß das Ausgangssignal $x_{ao}(t)$ merkliche Spektralanteile bei $f_A$, $2 f_A$ ... besitzt, wie aus Fig. 9 ersichtlich.

Eine interpolierende CCD-Ausgangsstufe gemäß der Erfindung besitzt für dieses CCD-Filter vorteilhaft die Übertragungsfunktion

$$H_A(z') = 0{,}0653 + 0{,}1285\,z'^{-1} + 0{,}1867\,z'^{-2} + 0{,}239\,z'^{-3} + 0{,}1867\,z'^{-4} + 0{,}1285\,z'^{-5} + 0{,}0653\,z'^{-6}.$$

Diese Tiefpaßfunktion kann mit bekannten Syntheseverfahren digitaler Filter ermittelt und für den konkreten Anwendungsfall optimiert werden.

Daraus erhält man für die Filter $H_j(z)$

$$H_1(z) = 0{,}0653 + 0{,}1867\,z^{-1}$$
$$H_2(z) = 0{,}1285 + 0{,}1285\,z^{-1}$$
$$H_3(z) = 0{,}1867 + 0{,}0653\,z^{-1}$$
$$H_4(z) = 0{,}239.$$

Fig. 8 zeigt die Realisierung der interpolierenden CCD-Ausgangsstufe. Die Koeffizienten werden durch die dort angegebenen Flächenverhältnisse bestimmt.

Die gesamte Übertragungsfunktion des CCD-Tiefpasses mit interpolierender Ausgangsstufe, Abtasthalteglied und RC-Tiefpaß ($f_g = 10$ kHz) ist in Fig. 10 dargestellt.

Gegenüber einem nachgeschalteten CCD-Tiefpaß höherer Taktfrequenz führt die Erfindung zu einem wesentlich geringeren Flächenbedarf bei der monolithischen Integration, sie braucht keinen weiteren Eingangs- und Ausgangswandler, sie braucht nur eine einfache Takterzeugung und ist außerdem für höhere Taktfrequenzen geeignet, weil kein Verstärker erforderlich ist und da bei ihr der Ladungstransport mit der Frequenz $f_A$ statt mit $f_A'$ erfolgt.

Gegenüber einem üblichen (LC-, bzw. RC-aktiven) Tiefpaßfilter wird durch die interpolierende CCD-Ausgangsstufe die Anforderung an die Flankensteilheit des nachgeschalteten Tiefpasses bei $m = 4$ um den Faktor 10 ... 20 reduziert, ein integrationsfähiges, toleranzunempfindliches RC-Glied reicht für das Tiefpaßfilter TP in der Regel aus.

**Patentansprüche**

1. Monolithisch integrierte Ladungsverschiebeschaltung, insbesondere für nichtrekursive Filter, mit einem Signalabtaster (AT), einem ersten durch den Signalabtaster mit Ladungspaketen versorgten, mit der Frequenz $f_A$ taktgesteuerten, m-Phasen-MIS-Ladungsverschiebesystem (H(w)) und einer diesem MIS-Ladungsverschiebesystem nachgeschalteten, der Wiederherstellung eines zeitkontinuierlichen Signals dienenden, taktgesteuerten, interpolierenden Ausgangsstufe mit Abtast-Halteglied (S+H), der ein Tiefpaß (TP', TP'') nachgeschaltet ist, dadurch gekennzeichnet, daß m MIS-Ladungsverschiebesysteme $(H_j(z) + (j-1)T')$, wobei m eine ganze Zahl größer/gleich 2 ist, parallel an den Ausgang des ersten Ladungsverschiebesystems (H(w)) angekoppelt sind und daß die den parallelen MIS-Ladungsverschiebesystemen zugeführten Ladungen durch gewichtete Aufspaltung des vom ersten Ladungsverschiebesystem abgegebenen Ladungspakets $(x_i(nT))$ entstehen, daß außerdem zur Steuerung dieser parallelen Ladungsverschiebesysteme dieselben m-phasigen Schiebetakte der Frequenz $f_A$ vorgesehen sind und daß außerdem diese MIS-Ladungsverschiebesysteme Filter gleicher oder unterschiedlicher Art bilden, daß ferner die von den parallelen Ladungsverschiebesystemen abgegebenen Ladungspakete $(x_i(nT))$ mit voneinander um $1/m \cdot f_A$ abgestuften Zeiten (T') verzögert und nach Umwandlung in eine Spannung zyklisch mit einer gegenüber der ersten Signalabtastfrequenz $f_A$ um den Faktor m höheren Abtastfrequenz $f_A'$ abgetastet werden und daß die Glättung dieser abgetasteten und gehaltenen Spannung durch ein integrationsfähiges, toleranzunempfindliches RC-Tiefpaßfilter (TP'') realisiert ist.

2. Vorrichtung nach Anspruch 1, dadurch gekennzeichnet, daß die durch die parallelen MIS-Ladungsverschiebesysteme $(H_j(z) + (j-1)T')$ zeitlich versetzt angegebenen Ladungspakete $(x_j'')$ in ein gemeinsames Diffusionsgebiet (D) einer an sich bekannten integrierten Ausführungsform einer Ausgangsschaltung für ladungsgekoppelte Schaltungen (CCD) gelangen und daß dieses Diffusionsgebiet (D) mit der am Ausgang erscheinenden höheren Abtastfrequenz $(f_A')$ in den Anfangszustand rückgesetzt wird.

3. Vorrichtung nach Anspruch 1 oder 2, dadurch gekennzeichnet, daß nach einer vom gemeinsamen Diffusionsgebiet (D) gesteuerten Sourcefolgerschaltung (SF) eine Abtast-Halte-Schaltung folgt, die

eine im Vergleich zur Taktfrequenz der MIS-Ladungsverschiebesysteme höhere Abtastfrequenz ($f_A'$) besitzt.

## Claims

1. A monolithic integrated CCD circuit, in particular for non-recursive filters, comprising a signal sampler (AT), a first m-phase MIS CCD system (H(w)) which is supplied with charge parcels by the signal sampler and is clock pulse controlled at a frequency $f_A$, and comprising a clock pulse controlled interpolating output stage connected following this MIS CCD system, serving to re-establish a time-continuous signal, and possessing a sample-and-hold element (S + H) followed by a low-pass filter (TP', TP''), characterised in that there are m MIS CCD systems ($H_j(z) + (J-1)T'$), where m is a whole number greater than or equal to 2, coupled in parallel to the output of the first CCD system (H(w)) and that the charges which are fed to the parallel MIS CCD systems are formed by weighted splitting of the charge parcel ($x_i(nT)$) emitted from the first CCD system, that in addition the same m-phase shift clock pulses of the frequency $f_A$ are provided for the control of these parallel CCD systems, these MIS CCD systems forming filters of identical or different types, the charge parcels ($x_i(nT)$) emitted from the parallel CCD systems being delayed by times (T') which are staggered relative to one another by $1/m \cdot f_A$, and following conversion into a voltage, are cyclically sampled at a sampling frequency $f_A'$ which exceeds the first signal sampling frequency $f_A$ by the factor m, and that the smoothing of this sampled maintained voltage is achieved by means of a RC low-pass filter (TP'') which is capable of integration and is insensitive to tolerance.

2. A device as claimed in Claim 1, characterised in that the charge parcels ($x_j''$) which are emitted in time staggered fashion by the parallel MIS CCD systems ($H_j(z) + (j-1)T'$) are fed to a common diffusion zone (D) of an integrated embodiment known per se of an output circuit for CCD circuits, and that this diffusion zone (D) is reset to the starting stage with the higher sampling frequency ($f_A'$) which appears at the output.

3. A device as claimed in Claim 1 or 2, characterised in that a source follower circuit (SF) which is controlled by the common diffusion zone (D) is followed by a samplehold circuit which possesses a sampling frequency ($f'_A$) which is higher than the clock pulse frequency of the MIS CCD systems.

## Revendications

1. Dispositif à transfert de charges intégré monolithiquement, notamment pour des filtres non récurrents, comportant un échantillonneur de signaux (AT), un premier système à transfert de charges MIS (métal-isolant-semiconducteur) à m phases (H(w)) commandé en cadence avec la fréquence $f_A$ et alimenté en paquets de charges par l'échantillonneur de signaux, et un étage de sortie interpolateur, commandé en cadence, servant à rétablir un signal continu dans le temps, branché en aval de ce système à transfert de charges MIS et comportant un élément d'échantillonnage et de maintien (S + H) en aval duquel est branché un filtre passe-bas (TP', TP''), caractérisé par le fait que m systèmes à transfert de charges MIS ($H_j(z) + (j-1)T'$), m étant un nombre entier supérieur ou égal à 2, sont montés en parallèle sur la sortie du premier système à transfert de charges (H(w)), et que les charges amenées aux systèmes à transfert de charges MIS en parallèle sont produites par subdivision pondérée du paquet de charges ($x_i(nT)$) délivré par le premier système à transfert de charges, qu'en outre pour la commande de ces systèmes à transfert de charges en parallèle sont prévues les mêmes cadences de décalage, à m phases, avec la fréquence $f_A$, et qu'en outre ces systèmes à transfert de charges MIS forment des filtres de même type ou de type différent, que d'autre part les paquets de charges ($x_i(nT)$) délivrés par les systèmes à transfert de charges en parallèle sont retardés de temps (T') décalés de $1/m \cdot f_A$ les uns par rapport aux autres et, après conversion en une tension, sont échantillonnés cycliquement avec une fréquence d'échantillonnage $f_A$ augmentée du facteur m par rapport à la première fréquence d'échantillonnage $f_A'$ des signaux, et que le lissage de cette tension échantillonnée et maintenue est effectué par un filtre passebas RC (TP'') pouvant être intégré et insensible aux tolérances.

2. Dispositif suivant la revendication 1, caractérisé par le fait que les paquets de charges ($x_j''$) délivrés de façon décalée dans le temps par les systèmes à transfert de charges MIS en parallèle ($H_j(z) + (j-1)T'$) arrivent dans une zone de diffusion commune (D) d'un mode de réalisation intégré connu en soi d'un circuit de sortie pour des dispositifs à couplage direct de charges (CCD), et que cette zone de diffusion (D) est remise dans l'état initial avec la fréquence d'échantillonnage plus élevée ($f_A'$) apparaissant à la sortie.

3. Dispositif suivant l'une des revendications 1 ou 2, caractérisé par le fait qu'après un circuit à source suiveuse (SF) commandé par la zone de diffusion commune (D) suit un circuit d'échantillonnage et de maintien qui possède une fréquence d'échantillonnage ($f_A'$) plus élevée que la fréquence de cadence des systèmes à transfert de charges MIS.

FIG1

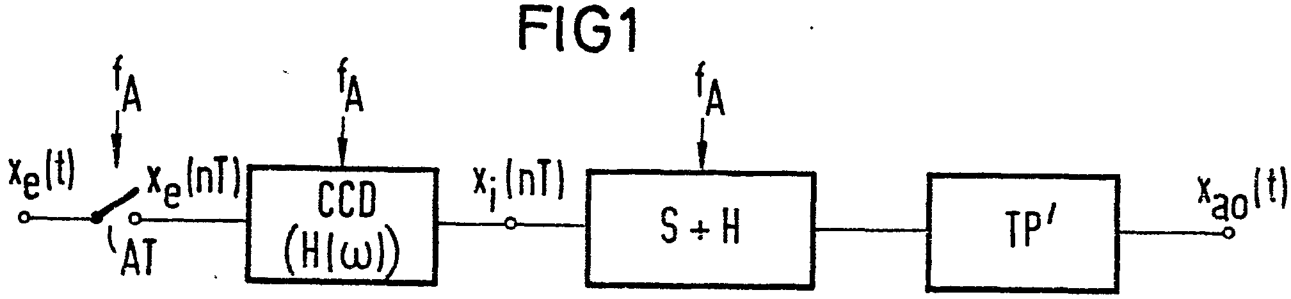


FIG 2

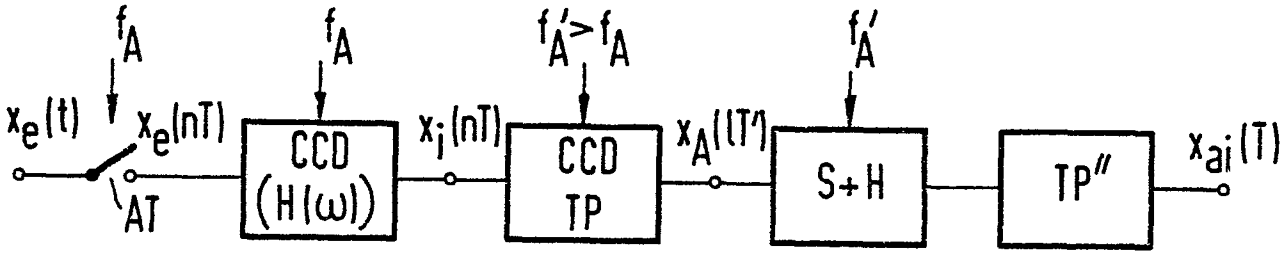


FIG 3

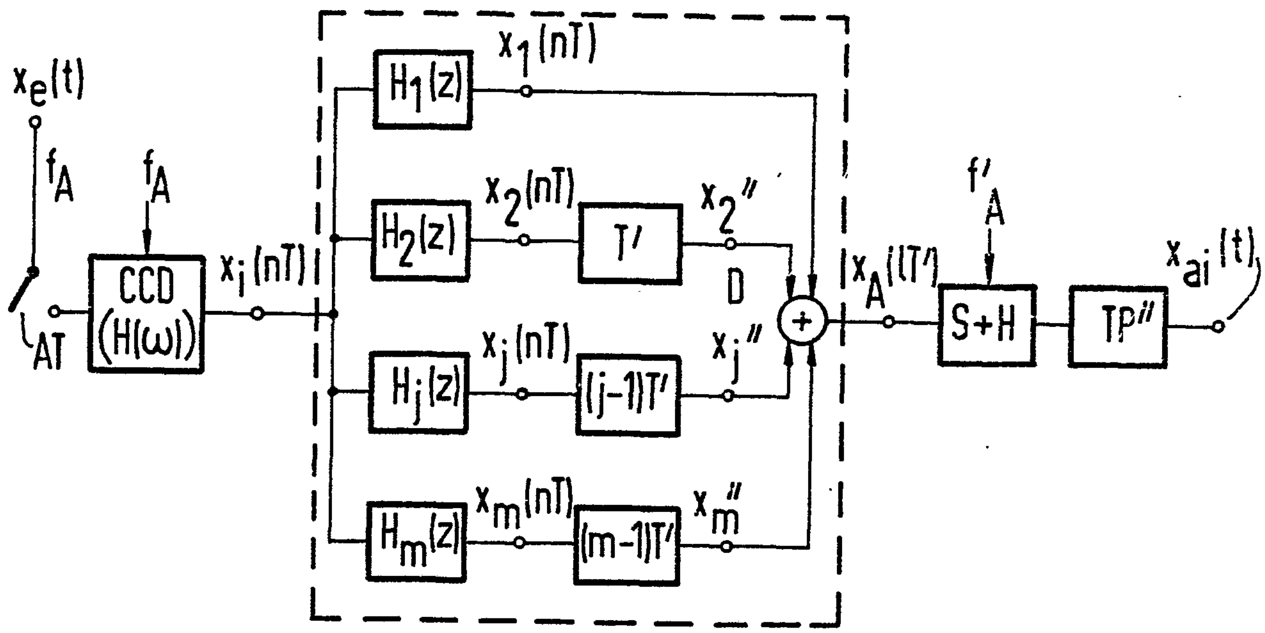


FIG 4

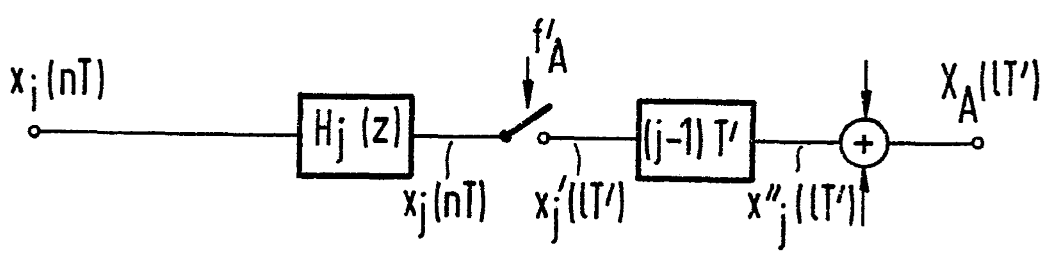

FIG5

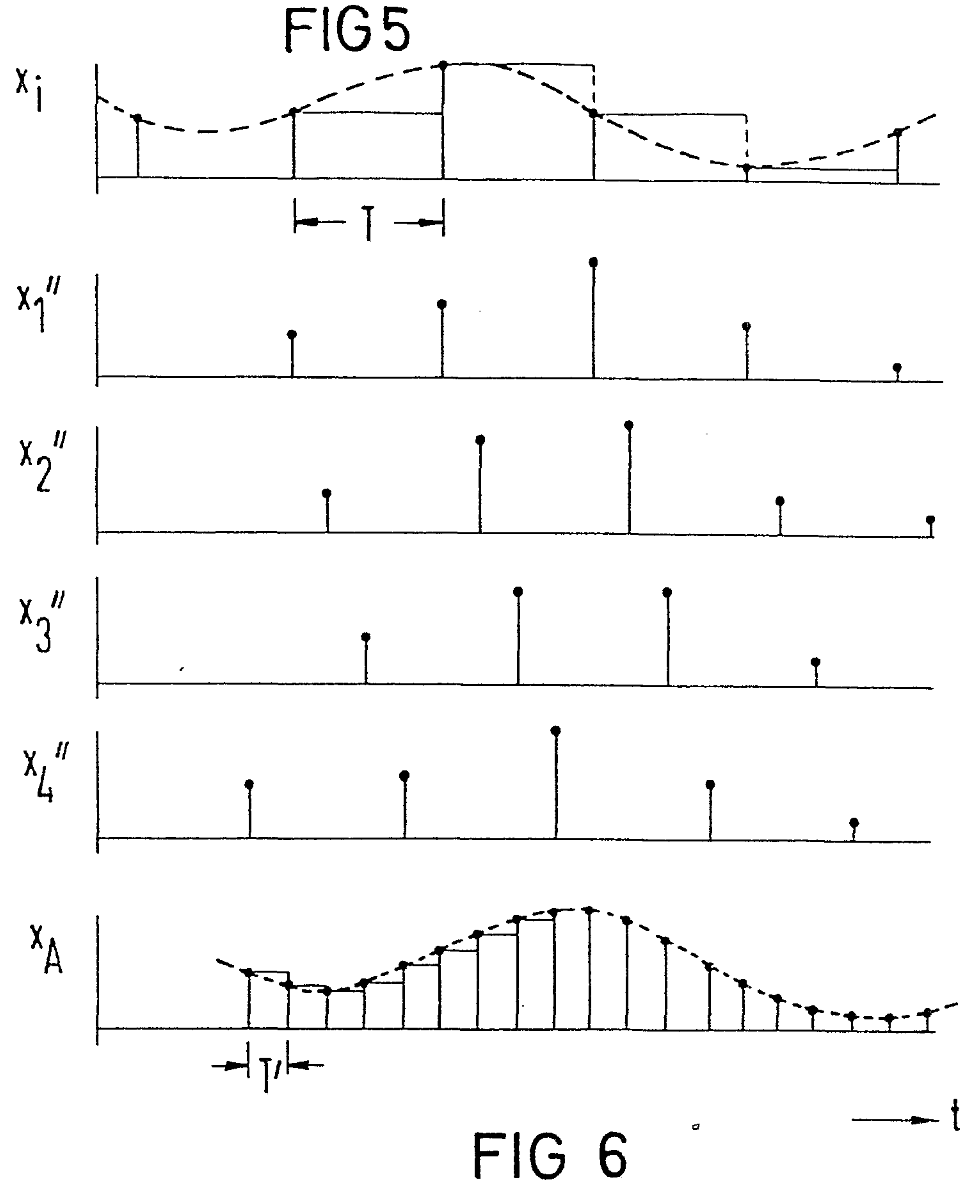


FIG 6

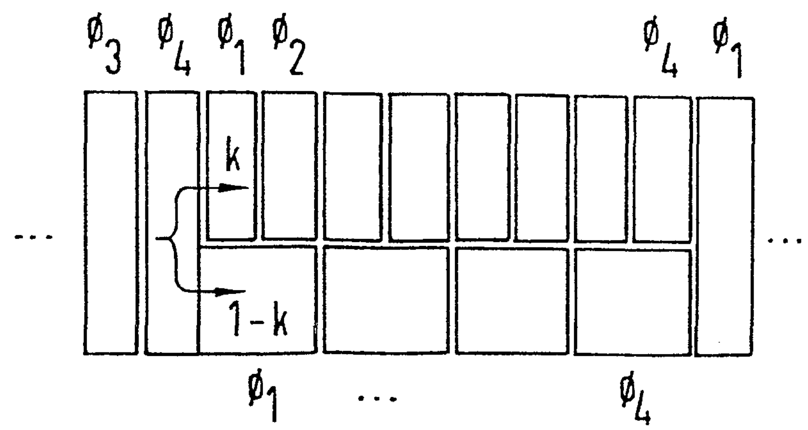


$$H(z) = (1-K)\left(1+\frac{K}{1-K}z^{-1}\right)$$

FIG 7

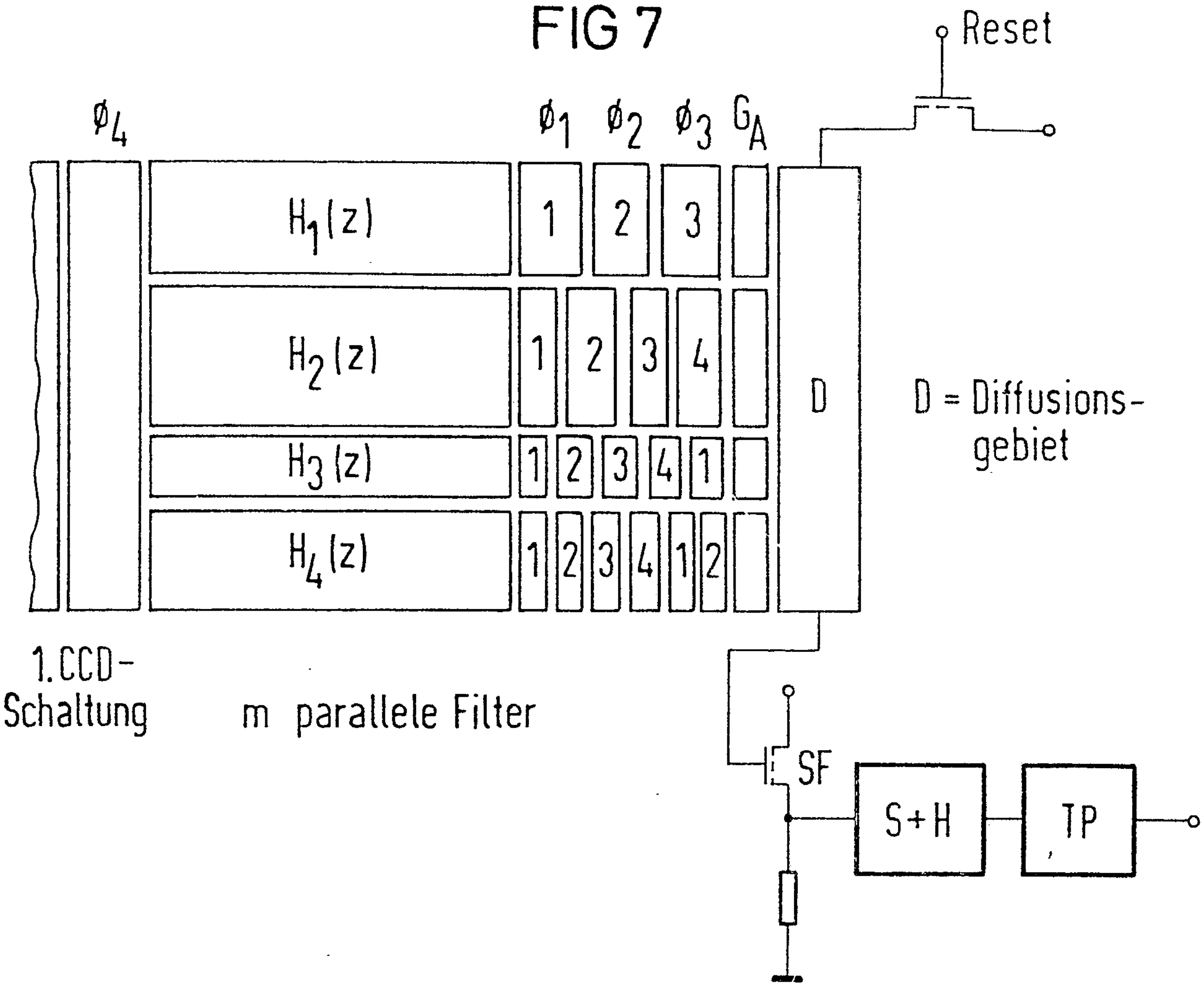


FIG 8

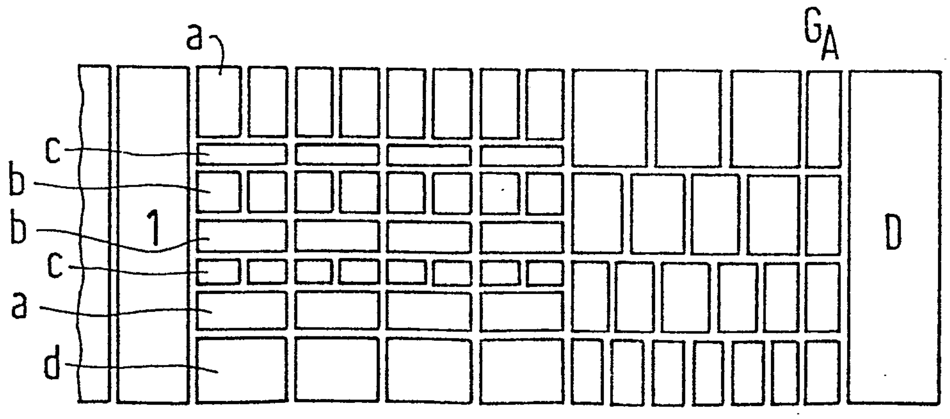


relative Flächen

a = 0 1867
b = 0 1285
c = 0 0653
d = 0 239

FIG 9

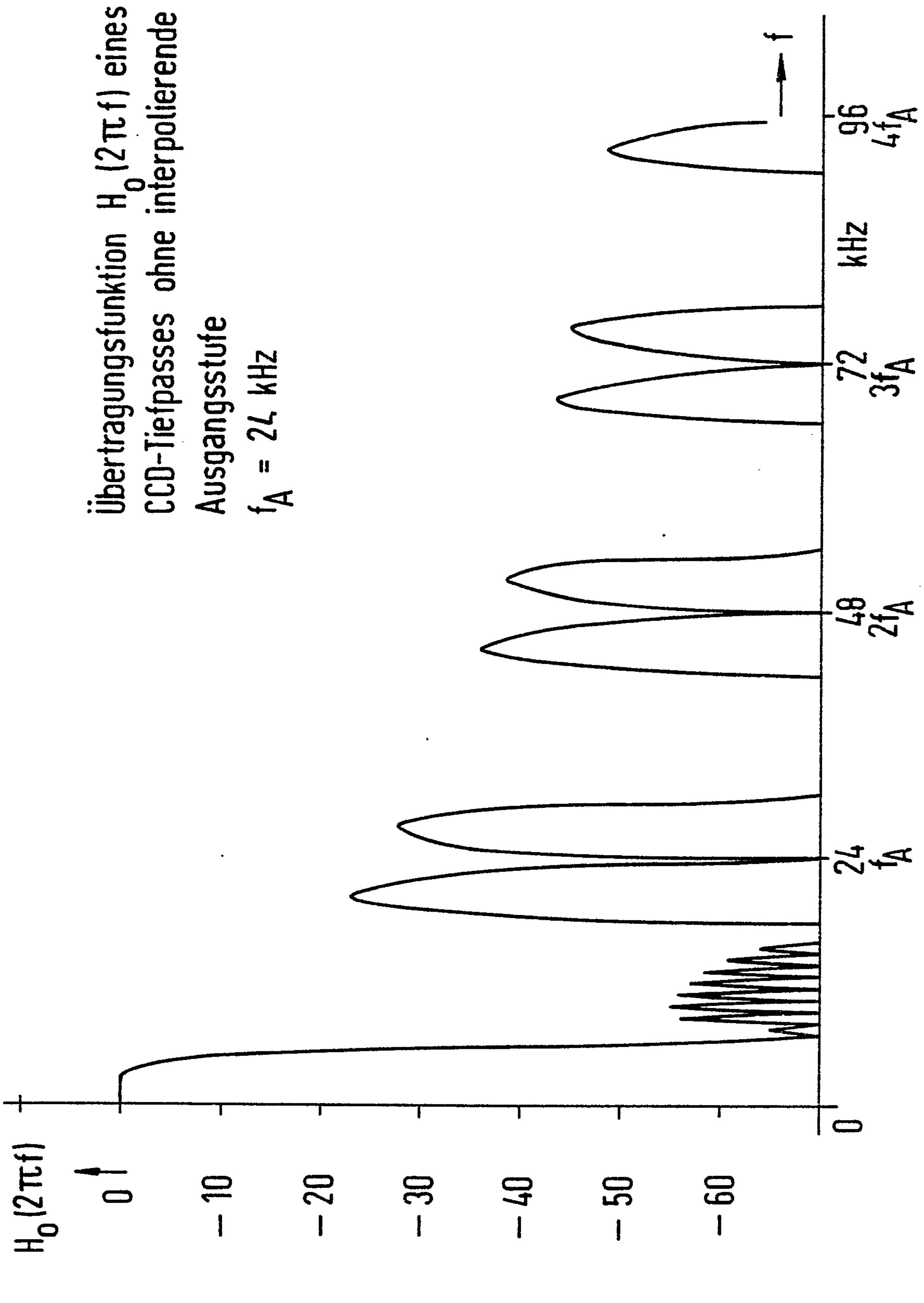

Übertragungsfunktion $H_o(2\pi f)$ eines
CCD-Tiefpasses ohne interpolierende
Ausgangsstufe
$f_A = 24$ kHz
$H_o(2\pi f)$
0
−10
−20
−30
−40
−50
−60
0
24
$f_A$
48
$2f_A$
72
$3f_A$
kHz
96
$4f_A$
f

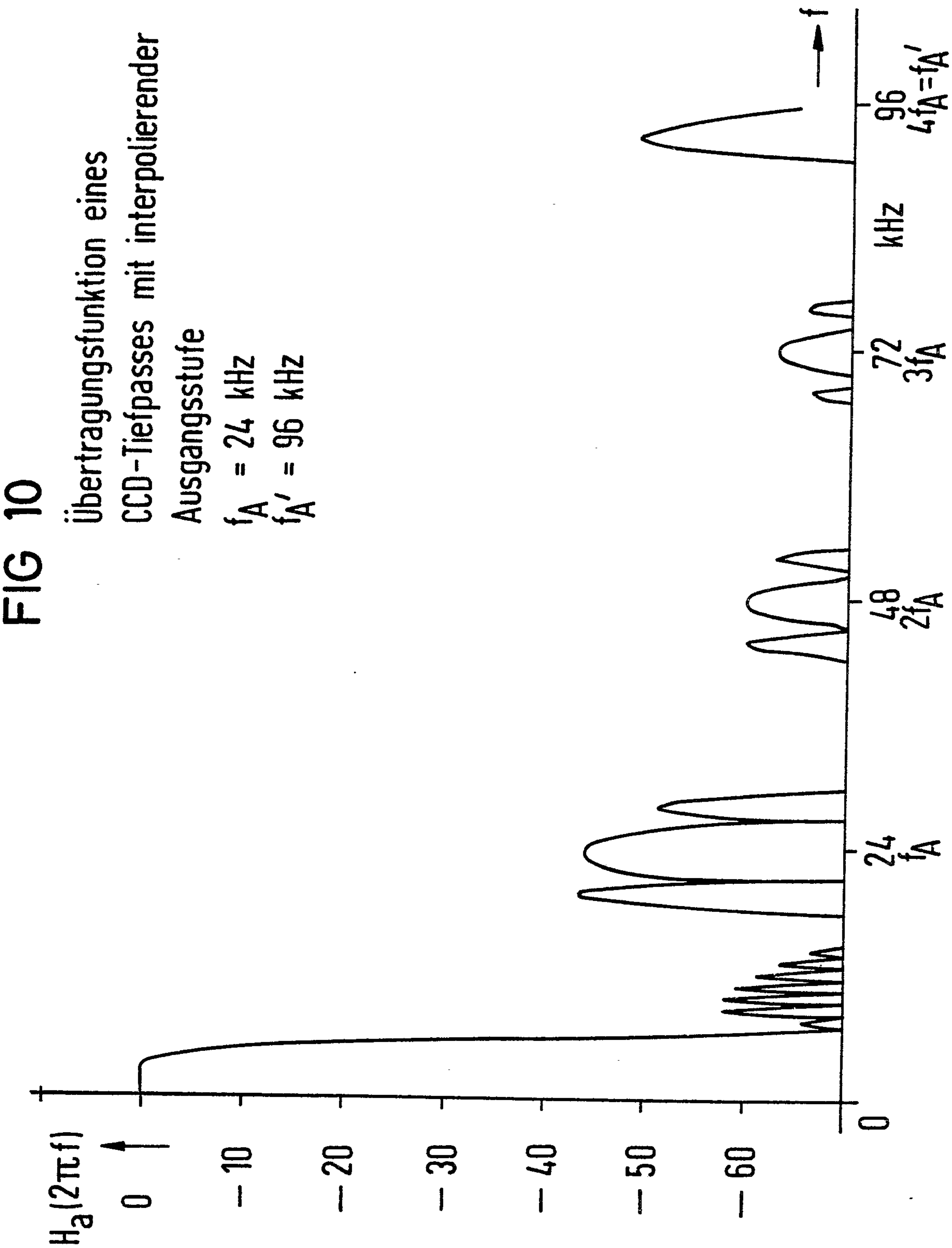


FIG 10

Übertragungsfunktion eines CCD-Tiefpasses mit interpolierender Ausgangsstufe

$f_A$ = 24 kHz

$f_A'$ = 96 kHz